# EUROPÄISCHE PATENTSCHRIFT

(11) **EP 1 424 698 B1**
(45) Veröffentlichungstag und Bekanntmachung des Hinweises auf die Patenterteilung: **21.05.2008**
(21) Anmeldenummer: 03026973.2
(22) Anmeldetag: 25.11.2003
(51) Int. Cl.: G11C 15/04

(54) **Cam (content addressable memory) - Vorrichtung**
Cam (content addressable memory) device
Dispositif Cam (content addressable memory)

(30) Priorität: 26.11.2002 DE 10261919
(43) Veröffentlichungstag der Anmeldung: 02.06.2004
(73) Patentinhaber: Infineon Technologies AG, 81669 München (DE)
(72) Erfinder: Hatsch, Joel, 82008 Unterhaching (DE); Kamp, Winfried, 81739 München (DE); Köppe, Siegmar, 81543 München (DE); Künemund, Thomas, 80337 München (DE); Söldner, Heinz, 83052 Bruckmühl-Heufeldmühle (DE); d'Argouges, Michel, 81479 München (DE)
(74) Vertreter: Reinhard - Skuhra - Weise & Partner

(56) Entgegenhaltungen:
- EP-A- 1 191 540
- WO-A-03/079369

## Beschreibung

Die vorliegende Erfindung betrifft eine CAM(Content Addressable Memory)-Vorrichtung, und insbesondere eine CAM-Vorrichtung für vorab dekodierte Suchwörter.

Integrierte Schaltungen weisen heutzutage häufig CAM-Vorrichtungen (Content Addressable Memories) auf. Dabei handelt es sich um Speichereinrichtungen, die nicht nur Lese- und Schreibzugriffe gestatten, sondern ebenfalls die Suche nach einem Eintrag im Speicher.

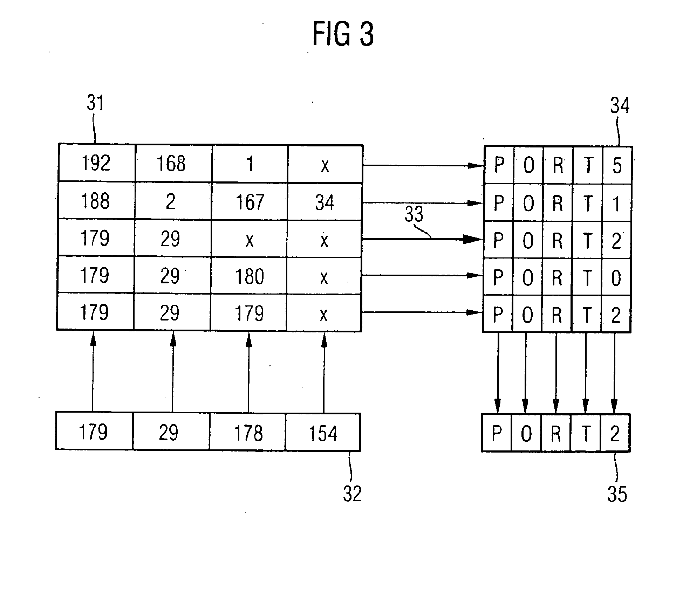

Der Betrieb eines CAMs nach dem Stand der Technik wird mit Bezug auf Figur 3 nachfolgend erläutert. In einem Ethernet-Router werden Verbindungsdaten gespeichert, welche dem Router mitteilen, welche IP-Adresse auf welchen Port zugewiesen ist und weitergeleitet werden soll. Dazu werden die IP-Adressen innerhalb eines CAM-Arrays 31 gespeichert. Empfängt der Router ein IP-Paket 32, so wird die IP-Adresse im Array 31 gesucht. Wenn sie gefunden wird, wird die zugehörige Hit-Leitung 33 aktiviert, welche ein gewöhnliches Speicher-Feld 34 ansteuert, in dem die Port-Nummer 35 abgelegt ist.

Ein weiteres Anwendungsgebiet in erster Linie für binäre CAMs eröffnet sich auf dem Gebiet der Cache-Speicher von Prozessoren. Diese Cache-Speicher ermöglichen der zentralen Recheneinheit CPU einen schnelleren Datenzugriff, als ein externer RAM-Speicher. In einem Cache-Speicher werden immer die aktuellen bzw. die zuletzt gespeicherten Daten abgespeichert, da die Wahrscheinlichkeit einer weiteren Verarbeitung dieser Daten sehr hoch ist. Da in diesem Einsatzfall die gespeicherten Adressbereiche stetig wechseln, wird zu jedem Datenwort auch das dazugehörige Adresswort abgespeichert. Über eine CAM-Vorrichtung wird dann nach dem gesuchten Adresswort gesucht und nach Auffinden desselben das dazugehörige Datenwort ausgegeben.

Bisher wurden CAM-Vorrichtungen üblicherweise aus CAM-Grundzellen aufgebaut, die jeweils ein Datenbit speichern und dieses Datenbit mit dem jeweiligen Suchwortbit mittels eines Komparators vergleichen. Für die Realisierung von Komparatoren sind mannigfaltige Alternativen bekannt. Neben statischen CMOS-Lösungen gibt es auch nichtkomplementäre oder dynamische Varianten, welche optional auch mit reduzierten Signalpegeln arbeiten können.

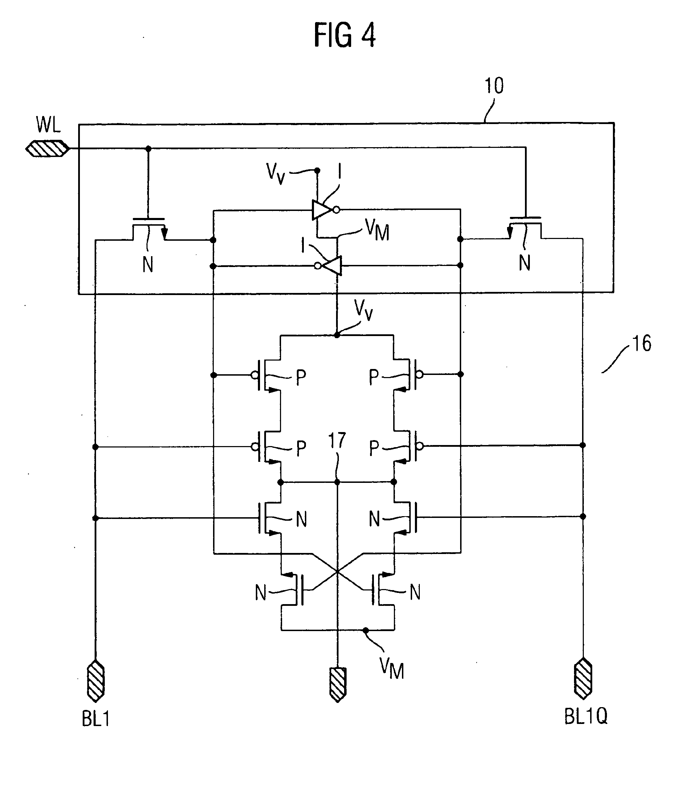

Normalerweise wird das Datenbit in einer 6-Transistor-SRAM Zelle oder einer daraus abgeleiteten Zelle, wie mit Bezug auf Figur 4 erläutert, gespeichert. Dazu werden alle Datenbits gleicher Wertigkeit über ein externes Bitleitungspaar BL1, BL1Q angeschlossen, wobei sich im Ruhezustand beide Bitleitungen BL1, BL1Q auf einem High-Pegel befinden (precharge). Beim Lesen, Schreiben und Vergleichen muss jeweils eine der beiden Bitleitungen BL1, BL1Q entladen werden, um das jeweilige Daten- bzw. Suchwortbit an den Zellen anzulegen. Dies bedeutet jedoch, dass bei allen Zugriffen auf die CAM-Vorrichtung jeweils eine Bit-Leitung pro Bit auf den jeweiligen Lowbit-Pegel entladen wird, welche in der darauffolgenden Precharge-Periode wieder auf den High-Pegel aufgeladen werden muss. Eine komplementäre Lösung, bei der die Vorladung auf einen Low-Pegel erfolgt, findet ebenfalls Verwendung. Problematisch dabei gestaltet sich vor allem die dabei auftretende Verlustleistung durch das ständige Ent- bzw. Aufladen einer Bitleitung pro Bit.

Patentanmeldung EP-A-1 191 540 aus dem Stand der Technik offenbart eine CAM-Vorrichtung mit einem Zweibit-Vergleichsschaltkreis.

Es ist daher die Aufgabe der vorliegenden Erfindung eine CAM-Vorrichtung bereitzustellen, welche eine geringe Verlustleistung aufweist.

Die der vorliegenden Erfindung zugrundeliegende Idee besteht im Wesentlichen darin, eine CAM-Vorrichtung bereitzustellen welche nicht eine Bitleitung/Vergleichsleitung pro Suchwortbit umlädt, sondern nur eine Bitleitung/Vergleichsleitung für zwei Suchwortbits vorsieht. Der Vergleich von zwei benachbarten Datenbits mit den zwei entsprechenden Suchwortbits wird dann mittels vierer Vergleichsleitungen parallel einem gemeinsamen Komparator zugeführt und dort verarbeitet. Die Erzeugung der vier Vergleichsleitungssignale, welche alle möglichen Zustände der beiden Suchwortbits repräsentieren, erfolgt vorzugsweise durch eine Vorverarbeitungseinrichtung außerhalb des CAM-Arrays.

Durch eine derartige Anordnung kann beim Vergleichen zum einen die Verlustleistung, welche beim Umladen der Bitleitungen bzw. der Vergleichsleitungen auftritt, halbiert werden. Andererseits kann die Hit-Leitung (Hit-Line), welche die Entscheidung von n lokalen Stufen zu einem globalen Ergebnis zusammenfasst, schneller bewertet werden, da nur noch halb so viele Vergleichsergebnisse zu bearbeiten sind.

In der vorliegenden Erfindung wird das eingangs erwähnte Problem insbesondere dadurch gelöst, dass eine CAM-Vorrichtung nach Anspruch 1 bereitgestellt wird.

In den Unteransprüchen finden sich vorteilhafte Weiterbildungen und Verbesserungen des Erfindungsgegenstandes.

Gemäß einer weiteren bevorzugten Weiterbildung weist die Komparatoreinrichtung eine Reihen-Parallelschaltung aus zwölf Feldeffekttransistoren eines ersten Leitungstyps auf.

Gemäß einer weiteren bevorzugten Weiterbildung weist die Komparatoreinrichtung vier parallel geschaltete Serienschaltungen aus jeweils drei Feldeffekttransistoren des ersten Leitungstyps auf.

Gemäß einer weiteren bevorzugten Weiterbildung weist die Komparatoreinrichtung eine Reihen-Parallelschaltung aus acht Feldeffekttransistoren eines ersten Leitungstyps auf.

Gemäß einer weiteren bevorzugten Weiterbildung ist der erste, zweite, dritte und vierte Speicherknoten der Speichereinrichtungen derart mit Gate-Anschlüssen zweier Feldeffekttransistoren des ersten Leitungstyps jeweils eines Pfades der Reihen-Parallelschaltung verbunden, dass für jede der vier aus 2 Bits möglichen Bitkombinationen ein Pfad durchschaltbar ist.

Gemäß einer weiteren bevorzugten Weiterbildung ist jeweils ein dritter Transistor eines der vier Pfade gateseitig jeweils mit einem der vier Eingänge zum Zuführen der zwei vorcodierten Vergleichsbits verbunden.

Gemäß einer weiteren bevorzugten Weiterbildung weist die Komparatoreinrichtung einen Feldeffekttransistor eines zweiten Leitungstyps mit einem Steueranschluss auf, der sich vom ersten Leitungstyp unterscheidet, und liegt zwischen dem Hit-Knoten und einem Bezugspotential.

Gemäß einer weiteren bevorzugten Weiterbildung ist der Feldeffekttransistor des zweiten Leistungstyps über den Steueranschluss durchschaltbar, wenn alle Vergleichsleitungen einen vorbestimmten Signalpegel aufweisen.

Gemäß einer weiteren bevorzugten Weiterbildung weist die Komparatoreinrichtung vier in Serie geschaltete Feldeffekttransistoren eines zweiten Leitungstyps auf, der sich vom ersten Leitungstyp unterscheidet.

Gemäß einer weiteren bevorzugten Weiterbildung liegen die vier Feldeffekttransistoren des zweiten Leitungstyps in Serie zu einer Reihen-Parallelschaltung aus Feldeffekttransistoren vom ersten Leitungstyp zwischen dem Hit-Knoten und einem Bezugspotential.

Gemäß einer weiteren bevorzugten Weiterbildung bilden die Feldeffekttransistoren vom ersten Leitungstyp einen P-Kanal und die Feldeffekttransistoren vom zweiten Leitungstyp einen N-Kanal.

Gemäß einer weiteren bevorzugten Weiterbildung bilden die Feldeffekttransistoren vom ersten Leitungstyp einen N-Kanal und die Feldeffekttransistoren vom zweiten Leitungstyp einen P-Kanal.

Gemäß einer weiteren bevorzugten Weiterbildung weist die Komparatoreinrichtung eine Halteeinrichtung zum Aufrechterhalten eines Signalpegels an den Hit-Knoten auf.

Gemäß einer weiteren bevorzugten Weiterbildung weist die Halteeinrichtung drei Transistoren auf, von denen ein erster und ein zweiter einen Inverter bilden, dessen Eingang mit dem Hit-Knoten verbunden ist, und dessen Ausgang an ein Gate des dritten Transistors angeschlossen ist.

Gemäß einer weiteren bevorzugten Weiterbildung ist eine der CAM-Vorrichtung vorgelagerte Schaltung zum Erzeugen der zwei vorcodierten Vergleichsbits statisch oder dynamisch betreibbar.

Gemäß einer weiteren bevorzugten Weiterbildung ist über den Hit-Knoten sowohl ein nachgelagerter Serien-Passgate-Hitpfad als auch ein Wired-Or-Hitpfad ansteuerbar.

Gemäß einer weiteren bevorzugten Weiterbildung sind die Speichereinrichtungen jeweils identisch aufgebaut.

Gemäß einer weiteren bevorzugten Weiterbildung weisen die Speichereinrichtungen jeweils sechs Transistoren auf, wobei vier davon zwei antiparallele Inverter bilden.

Ausführungsbeispiele der Erfindung sind in den Zeichnungen dargestellt und in der nachfolgenden Beschreibung näher erläutert.

Es zeigen:
- Figur 1, 1a: eine schematische Schaltungsanordnung zur Erläuterung einer ersten Ausführungsform der vorliegenden Erfindung, wobei Figur 1 einen erfindungsgemäßen Komparator und Figur 1a zwei exemplarische Speichereinrichtungen verdeutlicht;
- Figur 2, 2a: eine schematische Schaltungsanordnung zur Erläuterung einer zweiten Ausführungsform der vorliegenden Erfindung, wobei Figur 2 einen erfindungsgemäßen Komparator und Figur 2a zwei exemplarische Speichereinrichtungen verdeutlicht;
- Figur 3: ein Schaubild zur Erläuterung des bekannten CAM-Prinzips; und
- Figur 4: eine schematische Schaltungsanordnung zur Erläuterung einer üblichen CAM-Vorrichtung.

In den Figuren bezeichnen gleiche Bezugszeichen gleiche oder funktionsgleiche Bestandteile.

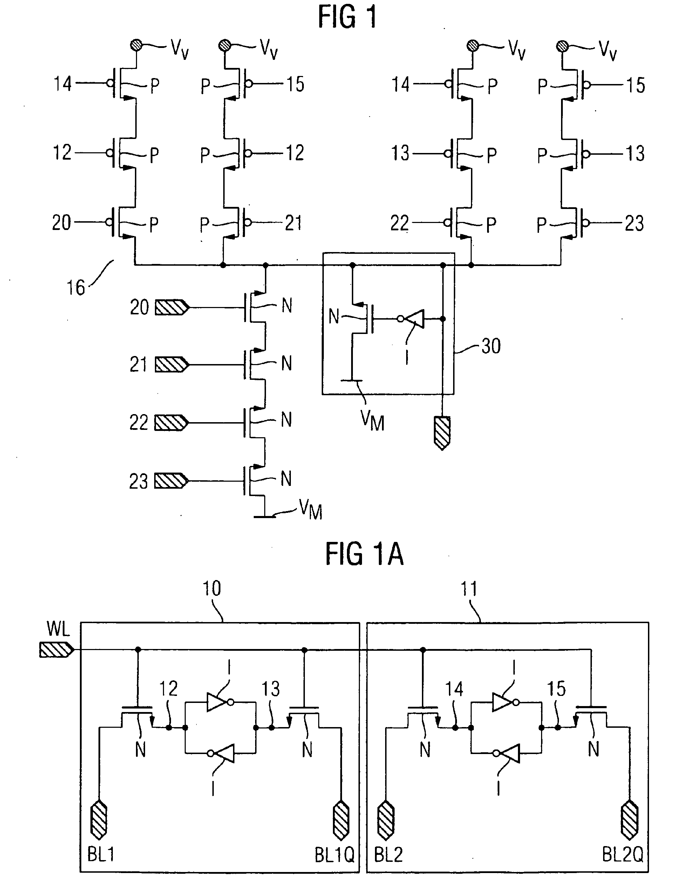

In Figur 1a sind eine erste exemplarische Speichereinrichtung 10 und eine zweite exemplarische Speichereinrichtung 11 dargestellt, welche im Wesentlichen identisch aufgebaut sind. In die Speichereinrichtung 10, 11 ist jeweils ein Bit über ein erstes Bitleitungspaar BL1, BL1Q bzw. über ein zweites Bitleitungspaar BL2, BL2Q in Abhängigkeit der Aktivierung über eine Wortleitung WL einschreib- und auslesbar. Eine Speichereinrichtung 10, 11 weist sechs Transistoren auf, von denen vier zwei antiparallel geschaltete Inverter I bilden. Die antiparallel geschalteten Inverter I liegen zwischen einem ersten Speicherknotenpunkt 12 und einem zweiten Speicherknotenpunkt 13, wobei die zweite Speichereinrichtung 11 einen dritten Speicherknoten 14 und einen vierten Speicherknoten 15 der Speichereinrichtung 10, 11 aufweist.

Über einen N-Kanal-Transistor, dessen Gate von der Wortleitung WL angesteuert wird, ist die Bitleitung BL1 mit dem ersten Speicherknoten 12 verbindbar. Der zweite Speicherknoten 13 ist ebenfalls über einen N-Kanal-Transistor N, welcher gateseitig über die Wortleitung WL angesteuert wird, mit der Bitleitung BL1Q verbindbar, welche beim Schreiben und Lesen das komplementäre Signal zu dem Signal auf der Bitleitung BL1 trägt. Für die zweite Speichereinrichtung 11 gilt Entsprechendes. Die 2-Bit-CAM-Zelle gemäß einer bevorzugten Ausführungsform basiert auf zwei statischen 6-Transistor RAM-Zellen 10, 11, die jeweils ein Bit eines abgespeicherten Datenwortes aufnehmen. Es besteht jedoch auch die Möglichkeit eine beliebige Speichereinrichtung einzusetzen, welche entsprechende Ausgänge 12, 13, 14, 15 aufweist. Sind keine komplementären Ausgänge 13, 15 vorhanden, so ist die Struktur gegebenenfalls durch jeweils einen Inverter I zu ergänzen, um solche komplementären Ausgänge zu generieren.

In Figur 1 ist eine Komparatoreinrichtung 16 dargestellt, welche zusammen mit der Speichereinrichtung 10, 11 eine CAM-Vorrichtung gemäß einer ersten Ausführungsform der vorliegenden Erfindung bildet. Die Komparatoreinrichtung 16 weist vier parallele Pfade mit jeweils drei in Reihe geschalteten P-Kanal-Feldeffekttransistoren P zwischen einer Versorgungsspannung V_{V} und einem Hitknoten 17 bzw. Match-Knoten 17 auf. Gateseitig ist ein erster P-Kanal-Transistor eines ersten der vier parallelen Pfade mit dem dritten Speicherknoten 14 der Speichereinrichtung 11 verbunden. Das Gate eines zweiten P-Kanal-Transistors P dieses ersten Pfades ist mit dem ersten Speicherknoten 12 der Speichereinrichtung 10 verbunden, und ein dritter P-Kanal-Transistor P in diesem ersten Pfad ist mit einer ersten Vergleichsleitung 20 verbunden.

Ein zweiter Pfad der vier parallelen Pfade weist einen ersten P-Kanal-Transistor P auf, dessen Gate mit dem vierten Speicherknoten 15 der Speichereinrichtung 11 verbunden ist, wobei ein zweiter P-Kanal-Transistor P gateseitig mit dem ersten Speicherknoten 12 der Speichereinrichtung 10 verbunden ist. Ein dritter P-Kanal Feldeffekttransistor P in diesem Zweig weist eine Verbindung zu einer zweiten Vergleichsleitung 21 auf.

Ein dritter Pfad der vier parallelen Pfade weisen einen ersten P-Kanal Feldeffekttransistor P auf, dessen Gate mit dem dritten Speicherknoten 14 der Speichereinrichtung 11 verbunden ist. Ein zweiter P-Kanal-Transistor des dritten Pfades weist eine gateseitige Verbindung zum zweiten Speicherknoten 13 der Speichereinrichtung 10 auf, und ein dritter P-Kanal Feldeffekttransistor P verfügt gateseitig über eine Verbindung zu einer Vergleichsleitung 22.

Ein vierter Pfad der vier parallelen Pfade schließlich sieht einen ersten P-Kanal-Transistor P vor, wobei dieser ein mit dem vierten Speicherknoten 15 verbundenes Gate aufweist. Darüber hinaus ist ein zweiter P-Kanal-Transistor gateseitig mit dem zweiten Speicherknoten 13 der Speichereinrichtung 10 in Verbindung, und ein dritter P-Kanal-Transistor P weist eine Verbindung zwischen seinem Gate und einer vierten Vergleichsleitung 23 auf.

Der Hit-Knoten 17 ist über eine Reihenschaltung aus 4 N-Kanal-Feldeffekttransistoren N mit einem Bezugspotential V_{M} verbindbar, wobei diese N-Kanal-Feldeffekttransistoren N gateseitig jeweils mit der ersten, zweiten, dritten und vierten Vergleichsleitung 20, 21, 22 und 23 verbunden sind. Jeweils die ersten zwei P-Kanal-Transistoren der vier parallelen Stränge sind folglich derart mit den speichernden Knoten 12, 13, 14 und 15 der Speichereinrichtungen 10, 11, d.h. der RAM-Zellen verbunden, dass jede der bei zwei Bit vier möglichen gespeicherten Datenbitkombinationen repräsentierbar ist. Durch diese Verschaltung wird sichergestellt, dass maximal nur eine der vier parallelen P-Kanal-Transistor-Serienschaltungen leitend werden kann. Jeweils der dritte Transistor P in den vier parallelen Pfaden ist mit einer der entsprechend vorcodierten Vergleichsleitungen 20, 21, 22, 23 verbunden.

Die Vorcodierung erfolgt vorzugsweise vorgelagert, sodass die erste Vergleichsleitung 20 beispielsweise aktiviert ist, d.h. mit einem Signal versehen, welches einen entsprechenden angeschlossenen Transistor P, N schaltet, wenn die Codierung der beiden Suchwortbits z.B. 00 ist. Entsprechendes gilt für die zweite Vergleichsleitung 21, welche z.B. 01 repräsentiert, wobei die dritte Vergleichsleitung 22 bei einer Codierung der beiden Suchwortbits von 10 aktiviert wird und entsprechend die vierte Vergleichsleitung 23 bei den Suchwortbits 11 einen entsprechend daran angeschlossenen Transistor (P- oder N-Kanal) schaltet.

Ist in der ersten Speichereinrichtung 10 als erstes Bit z.B. eine 0 eingeschrieben, liegt am ersten Speicherknoten 12 beispielsweise ein low-Pegel und am zweiten Speicherknoten 13 ein high-Pegel an. Ist in der zweiten Speichereinrichtung 11 als zweites Bit z.B. eine 0 eingeschrieben, liegt am dritten Speicherknoten 14 beispielsweise ein low-Pegel und am vierten Speicherknoten 15 ein high-Pegel an. Ist das Vergleichs-Bit-Paar nun ebenfalls 00, so liegt an der ersten Vergleichsleitung 20 ebenfalls ein low-Pegel an (alle anderen Vergleichsleitungen 21, 22, 23 sind auf high) und der linke äußere Strang wird durchgeschaltet, wobei das Potential am Hit-Knoten 17 auf V_{V} angehoben wird, d.h. ein positives Vergleichsergebnis wird ausgegeben. Ist das Vergleichs-Bit-Paar nun alternativ z.B. 01, so liegt an der zweiten Vergleichsleitung 21 ein low-Pegel an (alle anderen Vergleichsleitungen 20, 22, 23 sind auf high) keiner der Stränge wird durchgeschaltet und das Potential am Hit-Knoten 17 wird nicht angehoben, d.h. ein negatives Vergleichsergebnis wird ausgegeben.

Somit detektiert je nach Inhalt der beiden Speicher- bzw. RAM-Zellen 10, 11 genau eine der vier P-Kanal-Transistorreihenschaltungen die Gleichheit oder Ungleichheit der in den Speichereinrichtungen 10, 11 gespeicherten zwei Datenbits mit den beiden in den Vergleichsleitungen 20 bis 23 vorcodierten Vergleichsdatenbits.

Befindet sich die CAM-Vorrichtung wie beispielsweise vor jeder Suchoperation nicht im Suchmodus, werden vorzugsweise alle vier Vergleichsleitungen 20, 21, 22 und 23 deaktiviert, d.h. im Ausführungsbeispiel gemäß Figur 1 auf einen High-Pegel (V_{V}) gelegt. Durch die Serienschaltung der vier N-Kanal-Feldeffekttransistoren wird der Hit-Knoten 17 folglich auf den Low-Pegel (V_{M}) gelegt bzw. vorgeladen (Precharge). Detektiert die Komparatoreinrichtung 16 eine Gleichheit zwischen den zwei in der Speichereinrichtung 10, 11 gespeicherten Bits und den beiden Suchwortbits, so wird der Hit-Knoten 17 über genau eine der vier parallelen P-Kanal-Transistorreihenschaltungen auf den High-Pegel (V_{V}) umgeladen. Bei einer Ungleichheit hingegen, verbleibt der Hit-Knoten 17 auf dem zuvor initiierten Low-Pegel.

Um ein mögliches Schwanken des Potentials am Hit-Knoten 17 (floaten) bei einer längeren Phase der Ungleichheit zu unterdrücken, kann die Komparatoreinrichtung 16, wie im Ausführungsbeispiel dargestellt, um eine Halteeinrichtung 30 ergänzt werden. Die Halteeinrichtung 30 verfügt über einen Inverter I, der eingangsseitig mit dem Hit-Knoten 17 verbunden ist und an dessen Ausgang das Gate eines N-Kanal-Feldeffekttransistors N liegt. Dieser N-Kanal-Feldeffekttransistor N verbindet den Hit-Knoten 17 mit dem Bezugspotential V_{M}, solange das Potential am Hit-Knoten 17 einen vorbestimmten Wert nicht übersteigt.

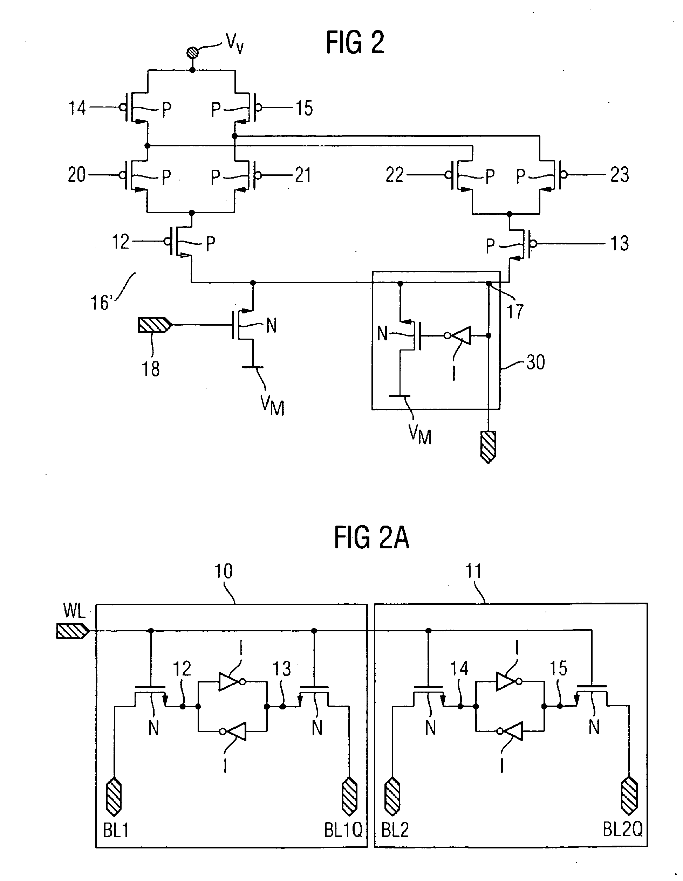

In Figur 2a ist eine identische Speicherschaltung wie die mit Bezug auf Figur 1a beschriebene, dargestellt.

Figur 2 zeigt ein im Aufwand im Vergleich zu Figur 1 reduziertes Ausführungsbeispiel mit nur 8 P-Kanal-Transistoren im Vergleich zu den 12-P-Kanal-Transistoren gemäß Figur 1.

Auch hier sind vier parallele Signalpfade über jeweils drei serielle P-Kanal-Feldeffekttransistoren P bereit gestellt. Ein erster Pfad zwischen einer Versorgungsspannung V_{V} und einem Hit-Knoten 17 verläuft über einen gateseitig mit dem dritten Speicherknoten 14 verbundenen Transistor, einen gateseitig mit der ersten Vergleichsleitung 20 verbundenen Transistor und einen gateseitig mit dem ersten Speicherknoten 12 verbundenen Transistor. Ein zweiter Pfad verläuft über einen gateseitig mit dem dritten Speicherknoten 14 verbundenen Transistor, einen gateseitig mit der dritten Vergleichsleitung 22 verbundenen Transistor und einen gateseitig mit dem zweiten Speicherknoten 13 verbundenen Transistor. Ein dritter Pfad wird über einen P-Kanal-Transistor P, welcher gateseitig mit dem vierten Speicherknoten 15 verbunden ist, einen gateseitig mit der zweiten Vergleichsleitung 21 verbundenen Transistor und einen gateseitig mit dem ersten Speicherknoten 12 verbundenen Transistor P bereitgestellt. Schließlich ergibt sich ein vierter Pfad über den gateseitig mit dem vierten Speicherknoten 15 verbundenen P-Kanal-Feldeffekttransistor P, einen ebensolchen gateseitig mit der vierten Vergleichsleitung 23 verbundenen Transistor und einen gateseitig mit dem zweiten Speicherknoten 13 verbundenen P-Kanal-Feldeffekttransistor P.

Im Gegensatz zu Figur 1 treten in dem Ausführungsbeispiel gemäß Figur 2 nur zwei anstatt vier erste Transistoren, einer gateseitig mit dem dritten Speicherknoten 14 und der andere gateseitig mit dem vierten Speicherknoten 15 verbunden auf, welche bis dahin nur zwei Pfade auf vier Pfade mit vier im Pfad liegenden P-Kanal-Feldeffekttransistoren P, welche gateseitig mit der ersten, zweiten, dritten und vierten Vergleichsleitung 20, 21, 22 und 23 zum Zuführen zweier vorcodierter Vergleichsbits verbunden sind, aufspalten, um dann wieder über zwei Transistoren, welche gateseitig mit dem ersten und zweiten Speicherknoten 12, 13 verbunden sind auf zwei Pfade zusammengefasst zu werden. Anstelle der mit Bezug auf Figur 1 beschriebenen Serienschaltung aus 4 N-Kanal- Feldeffekttransistoren N ist gemäß Figur 2 ein N-Kanal- Feldeffekttransistor N mit einem Steueranschluß 18 vorgesehen. Dieser einzelne N-Kanal-Feldeffekttransistor ist durchgeschaltet, wenn alle vier Vergleichsleitungen 20, 21, 22, 23 inaktiv sind.

Beim Ausführungsbeispiel gemäß Figur 2 wird neben der Anzahl der Transistoren der P-Kanal-Transistorpfade auch die Belastung der internen Knoten jeder Speicherzelle 12, 13, 14 und 15 in etwa halbiert.

Obwohl die vorliegende Erfindung vorstehend anhand zweier bevorzugter Ausführungsbeispiele beschrieben wurde, ist sie darauf nicht beschränkt, sondern auf vielfältige Weise modifizierbar.

So kann vor allem der Komparator auch komplementär aufgebaut bzw. angeschlossen werden, d.h. die Transistoren eines ersten Leitungstyps z.B. P-Kanal-Transistoren können durch Transistoren des anderen Leitungstyps (z.B. N-Kanal-Transistoren) ersetzt werden und umgekehrt. Darüber hinaus kann eine Schaltung zur Erzeugung der Vergleichssignale auf den Vergleichsleitungen 20, 21, 22 und 23 je nach CAM-Umgebung statisch oder dynamisch betrieben werden. Schließlich kann der Hitpfad-Knoten 17 sowohl einen Serien-Passgate-Hitpfad oder einen Wired-Or-Hitpfad ansteuern.

Der 4-fach N-Kanal Transistor Serienpfad kann in jeglicher Weise derart ersetzt werden, daß wenn alle Vergleichsleitungen 20, 21, 22, 23 inaktiv sind der Hitknoten 17 geeignet vorgeladen wird (gemäß Fig. 2 auf Potential V_{M}). Beispielsweise erfolgt dies über einen einzelnen N-Kanal Transistor mit gesonderter Steuerleitung 18.

Zur Speicherung der beiden Datenbits in den Speichereinrichtungen 10, 11 kann jede beliebige andere Speicherstruktur zum Einsatz kommen. Liefern die eingesetzten Speicherstrukturen keine komplementären Ausgänge 13, 15, so ist die Komparatorstruktur gegebenenfalls geignet durch zwei Inverter I zu erweitern.

### Bezugszeichenliste

- 10: Speichereinrichtung
- 11: Speichereinrichtung
- 12: erster Speicherknoten
- 13: zweiter Speicherknoten
- 14: dritter Speicherknoten
- 15: vierter Speicherknoten
- 16: Komparatoreinrichtung
- 17: Hit-Knoten
- 18: Ansteuerleitung

- 20: erste vorkodierte Vergleichsleitung
- 21: zweite vorkodierte Vergleichsleitung
- 22: dritte vorkodierte Vergleichsleitung
- 23: vierte vorkodierte Vergleichsleitung

- 30: Halteeinrichtung
- 31: CAM-feld (content addressable memory array)
- 32: IP-Paket
- 33: Hit-Leitung
- 34: Speicherfeld
- 35: Port-Nummer

- BL1: Bitleitung
- BL1Q: Bitleitung mit inversem Signal zu BL1
- BL2: Bitleitung
- BL2Q: Bitleitung mit inversem Signal zu BL2
- V_{V}: Versorgungsspannung
- V_{M}: Bezugspotential, z.B. Masse
- N: N-Kanal Feldeffekttransistor
- P: P-Kanal Feldeffekttransistor

## Patentansprüche

1. CAM (content adressable memory) -Vorrichtung mit:
einer ersten Speichereinrichtung (10) mit einem Wortleitungseingang (WL) und mindestens einem Speicherknoten (12; 13) zum Speichern eines ersten Bits eines Datenwortes;
einer zweiten Speichereinrichtung (11) mit einem Wortleitungseingang (WL) und mindestens einem Speicherknoten (14; 15) zum Speichern eines zweiten Bits eines Datenwortes; und
einer Komparatoreinrichtung (16) zum Vergleichen des ersten und zweiten gespeicherten Bits mit zwei über vier Eingänge (20; 21; 22; 23) zugeführten vorkodierten Vergleichsbits und zum Ansteuern eines Hit-Knoten (17) bei Übereinstimmung des ersten gespeicherten Bits mit dem ersten Vergleichsbit und des zweiten gespeicherten Bits mit dem zweiten Vergleichsbit
**dadurch gekennzeichnet,**
**dass** die Komparatoreinrichtung (16) vier Signalpfade über jeweils drei Transistoren (P; N) zwischen einer Versorgungsspannung (V_{V}) und dem Hit-Knoten (17) aufweist.

2. CAM- Vorrichtung nach Anspruch 1,
**dadurch gekennzeichnet,**
**dass** die Komparatoreinrichtung (16) eine Reihen- Parallelschaltung aus zwölf Feldeffekttransistoren (P; N) eines ersten Leitungstyps aufweist.

3. CAM- Vorrichtung nach Anspruch 2,
**dadurch gekennzeichnet,**
**dass** die Komparatoreinrichtung (16) vier parallel geschaltete Serienschaltungen aus jeweils drei Feldeffekttransistoren (P; N) des ersten Leitungstyps aufweist.

4. CAM- Vorrichtung nach Anspruch 1,
**dadurch gekennzeichnet,**
**dass** die Komparatoreinrichtung (16) eine Reihen- Parallelschaltung aus acht Feldeffekttransistoren (P; N) eines ersten Leitungstyps aufweist.

5. CAM- Vorrichtung nach einem der vorangehenden Ansprüche 1 bis 4,
**dadurch gekennzeichnet,**
**dass** ein erster, zweiter, dritter und vierter Speicherknoten (12; 13; 14; 15) der Speichereinrichtungen (10; 11) derart mit Gate- Anschlüssen eines ersten und zweiten Feldeffekttransistors (P; N) des ersten Leitungstyps jeweils eines Pfades einer Reihen- Parallelschaltung verbunden sind, dass durch jede der vier aus zwei Bits möglichen Bitkombinationen genau ein Pfad durchschaltbar ist.

6. CAM- Vorrichtung nach Anspruch 5,
**dadurch gekennzeichnet,**
**dass** jeweils ein dritter Transistor eines der vier Pfade gate-seitig jeweils mit einem der vier Eingänge (20, 21, 22, 23) zum Zuführen der zwei vorkodierten Vergleichsbits verbunden ist.

7. CAM- Vorrichtung nach einem der vorangehenden Ansprüche 2 bis 6,
**dadurch gekennzeichnet,**
**dass** die Komparatoreinrichtung (16) einen Feldeffekttransistor (N; P) eines zweiten Leitungstyps mit einem Steueranschluss (18) aufweist, der sich vom ersten Leitungstyp unterscheidet, und zwischen dem Hit-Knoten (17) und einem Bezugspotential (V_{M}) liegt.

8. CAM- Vorrichtung nach Anspruch 7,
**dadurch gekennzeichnet,**
**dass** der Feldeffekttransistor (N; P) des zweiten Leistungstyps über den Steueranschluss (18) durchschaltbar ist, wenn alle Vergleichsleitungen (20, 21, 22, 23) einen vorbestimmten Signalpegel aufweisen.

9. CAM- Vorrichtung nach einem der vorangehenden Ansprüche 2 bis 8,
**dadurch gekennzeichnet,**
**dass** die Komparatoreinrichtung (16) vier in Serie geschaltete Feldeffekttransistoren (N; P) eines zweiten Leitungstyps aufweist, der sich vom ersten Leitungstyp unterscheidet.

10. CAM- Vorrichtung nach Anspruch 9,
**dadurch gekennzeichnet,**
**dass** die vier Feldeffekttransistoren (N; P) des zweiten Leitungstyp in Serie zu einer Reihen- Parallelschaltung aus Feldeffekttransistoren (P; N) vom ersten Leitungstyp zwischen dem Hit-Knoten (17) und einem Bezugspotential (V_{M}) liegen.

11. CAM- Vorrichtung nach einem der vorangehenden Ansprüche 7 bis 10,
**dadurch gekennzeichnet,**
**dass** die Feldeffekttransistoren (P; N) vom ersten Leitungstyp einen p-Kanal und die Feldeffekttransistoren (N; P) vom zweiten Leitungstyp einen n-Kanal bilden.

12. CAM- Vorrichtung nach einem der vorangehenden Ansprüche 7 bis 10,
**dadurch gekennzeichnet,**
**dass** die Feldeffekttransistoren (P; N) vom ersten Leitungstyp einen n-Kanal und die Feldeffekttransistoren (N; P) vom zweiten Leitungstyp einen p-Kanal bilden.

13. CAM- Vorrichtung nach einem der vorangehenden Ansprüche,
**dadurch gekennzeichnet,**
**dass** die Komparatoreinrichtung (16) eine Halteeinrichtung (30) zum Aufrechterhalten eines Signalpegels an dem Hit-Knoten (17) aufweist.

14. CAM- Vorrichtung nach Anspruch 13,
**dadurch gekennzeichnet,**
**dass** die Halteeinrichtung drei Transistoren aufweist, von denen ein erster und ein zweiter einen Inverter (I) bilden, dessen Eingang mit dem Hit-Knoten (17) verbunden ist, und dessen Ausgang an ein Gate des dritten Transistors (N; P) angeschlossen ist.

15. CAM- Vorrichtung nach einem der vorangehenden Ansprüche,
**dadurch gekennzeichnet,**
**dass** eine der CAM- Vorrichtung vorgelagerte Schaltung zum Erzeugen der zwei vorkodierten Vergleichsbits statisch oder dynamisch betreibbar ist.

16. CAM- Vorrichtung nach einem der vorangehenden Ansprüche,
**dadurch gekennzeichnet,**
**dass** über den Hit-Knoten (17) sowohl ein nachgelagerter Serien-Passgate-Hitpfad als auch ein Wired-Or-Hitpfad ansteuerbar ist.

17. CAM- Vorrichtung nach einem der vorangehenden Ansprüche,
**dadurch gekennzeichnet,**
**dass** die Speichereinrichtungen (10; 11) jeweils identisch aufgebaut sind und jeweils sechs Transistoren aufweisen, wobei vier davon zwei antiparallele Inverter (I) bilden.

## Claims

1. CAM (content addressable memory) apparatus having:
a first memory device (10) with a word line input (WL) and at least one storage node (12; 13) for storing a first bit of a data word;
a second memory device (11) with a word line input (WL) and at least one storage node (14; 15) for storing a second bit of a data word; and
a comparator device (16) for comparing the first and second stored bits with two precoded comparison bits fed via four inputs (20; 21; 22; 23) and for driving a hit node (17) in the event of the first stored bit corresponding to the first comparison bit and the second stored bit corresponding to the second comparison bit,
**characterized**
**in that** the comparator device (16) has four signal paths via in each case three transistors (P; N) between a supply voltage (V_{V}) and the hit node (17).

2. CAM apparatus according to Claim 1,
**characterized**
**in that** the comparator device (16) has a series-parallel circuit comprising twelve field-effect transistors (P; N) of a first conduction type.

3. CAM apparatus according to Claim 2,
**characterized**
**in that** the comparator device (16) has four parallel-connected series circuits comprising in each case three field-effect transistors (P; N) of the first conduction type.

4. CAM apparatus according to Claim 1,
**characterized**
**in that** the comparator device (16) has a series-parallel circuit comprising eight field-effect transistors (P; N) of a first conduction type.

5. CAM apparatus according to one of the preceding Claims 1 to 4,
**characterized**
**in that** a first, second, third and fourth storage node (12; 13; 14; 15) of the memory devices (10; 11) are connected to gate terminals of a first and second field-effect transistor (P; N) of the first conduction type of a respective path of a series-parallel circuit in such a way that precisely one path can be switched through by each of the four bit combinations possible from two bits.

6. CAM apparatus according to Claim 5,
**characterized**
**in that** a respective third transistor of one of the four paths is connected, on the gate side, in each case to one of the four inputs (20, 21, 22, 23) for feeding the two precoded comparison bits.

7. CAM apparatus according to one of the preceding Claims 2 to 6,
**characterized**
**in that** the comparator device (16) has a field-effect transistor (N; P) of a second conduction type with a control terminal (18), which differs from the first conduction type, and is located between the hit node (17) and a reference potential (V_{M}).

8. CAM apparatus according to Claim 7,
**characterized**
**in that** the field-effect transistor (N; P) of the second power type can be switched through via the control terminal (18) if all the comparison lines (20, 21, 22, 23) have a predetermined signal level.

9. CAM apparatus according to one of the preceding Claims 2 to 8,
**characterized**
**in that** the comparator device (16) has four series-connected field-effect transistors (N; P) of a second conduction type, which differs from the first conduction type.

10. CAM apparatus according to Claim 9,
**characterized**
**in that** the four field-effect transistors (N; P) of the second conduction type are connected in series with a series-parallel circuit comprising field-effect transistors (P; N) of the first conduction type between the hit node (17) and a reference potential (V_{M}).

11. CAM apparatus according to one of the preceding Claims 7 to 10,
**characterized**
**in that** the field-effect transistors (P; N) of the first conduction type form a p channel and the field-effect transistors (N; P) of the second conduction type form an n channel.

12. CAM apparatus according to one of the preceding Claims 7 to 10,
**characterized**
**in that** the field-effect transistors (P; N) of the first conduction type form an n channel and the field-effect transistors (N; P) of the second conduction type form an p channel.

13. CAM apparatus according to one of the preceding claims,
**characterized**
**in that** the comparator device (16) has a holding device (30) for maintaining a signal level at the hit node (17).

14. CAM apparatus according to Claim 13,
**characterized**
**in that** the holding device has three transistors, of which a first and a second form an inverter (I), the input of which is connected to the hit node (17), and the output of which is connected to a gate of the third transistor (N; P).

15. CAM apparatus according to one of the preceding claims,
**characterized**
**in that** a circuit which is upstream of the CAM apparatus and serves for generating the two precoded comparison bits can be operated statically or dynamically.

16. CAM apparatus according to one of the preceding claims,
**characterized**
**in that** both a downstream series pass gate hit path and a wired-Or hit path can be driven via the hit node (17).

17. CAM apparatus according to one of the preceding claims,
**characterized**
**in that** the memory devices (10; 11) are in each case constructed identically and in each case have six transistors, four of which form two antiparallel inverters (I).

## Revendications

1. Dispositif CAM (content addressable memory) avec :
- un premier dispositif de mémorisation (10) avec une entrée de ligne de mot (WL) et avec au moins un noeud de mémorisation (12 ; 13) pour la mémorisation d'un premier bit d'un mot de données ;
- un deuxième dispositif de mémorisation (11) avec une entrée de ligne de mot (WL) et avec au moins un noeud de mémorisation (14 ; 15) pour la mémorisation d'un deuxième bit d'un mot de données ; et
- un dispositif de comparaison (16) pour la comparaison du premier et du deuxième bit mémorisé à deux bits de comparaison précodés amenés par l'intermédiaire de quatre entrées (20 ; 21 ; 22 ; 23) et pour la commande d'un noeud de coïncidence (17) en cas de coïncidence du premier bit mémorisé avec le premier bit de comparaison et du deuxième bit mémorisé avec le deuxième bit de comparaison,
**caractérisé par le fait que** le dispositif de comparaison (16) comporte quatre trajets de signal passant à chaque fois par trois transistors (P ; N) entre une tension d'alimentation (V_{V}) et le noeud de coïncidence (17).

2. Dispositif CAM selon la revendication 1,
**caractérisé par le fait que** le dispositif de comparaison (16) comporte un circuit série - parallèle de douze transistors à effet de champ (P ; N) d'un premier type de conductivité.

3. Dispositif CAM selon la revendication 2,
**caractérisé par le fait que** le dispositif de comparaison (16) comporte quatre circuits en série branchés en parallèle et constitués chacun de trois transistors à effet de champ (P ; N) du premier type de conductivité.

4. Dispositif CAM selon la revendication 1,
**caractérisé par le fait que** le dispositif de comparaison (16) comporte un circuit série - parallèle de huit transistors à effet de champ (P ; N) d'un premier type de conductivité.

5. Dispositif CAM selon l'une des revendications précédentes 1 à 4,
**caractérisé par le fait qu'**un premier, deuxième, troisième et quatrième noeud de mémorisation (12 ; 13 ; 14 ; 15) des dispositifs de mémorisation (10 ; 11) sont reliés à des bornes de grille d'un premier et d'un deuxième transistor à effet de champ (P ; N) du premier type de conductivité à chaque fois d'un trajet d'un circuit série - parallèle de telle sorte que l'on peut faire passer exactement un trajet par chacune des quatre combinaisons de bits possibles à partir de deux bits.

6. Dispositif CAM selon la revendication 5,
**caractérisé par le fait que**, à chaque fois, un troisième transistor de l'un des quatre trajets est relié côté grille à l'une des quatre entrées (20, 21, 22, 23) pour l'amenée des deux bits de comparaison précodés.

7. Dispositif CAM selon l'une des revendications précédentes 2 à 6,
**caractérisé par le fait que** le dispositif de comparaison (16) comporte un transistor à effet de champ (N ; P) d'un deuxième type de conductivité avec une borne de commande (18), lequel deuxième type de conductivité est différent du premier type de conductivité, ce transistor à effet de champ se trouvant entre le noeud de coïncidence (17) et un potentiel de référence (V_{M}).

8. Dispositif CAM selon la revendication 7,
**caractérisé par le fait que** le transistor à effet de champ (N ; P) du deuxième type de conductivité est connectable par l'intermédiaire de la borne de commande (18) lorsque toutes les lignes de comparaison (20, 21, 22, 23) ont un niveau de signal prédéterminé.

9. Dispositif CAM selon l'une des revendications précédentes 2 à 8,
**caractérisé par le fait que** le dispositif de comparaison (16) comporte quatre transistors à effet de champ (N ; P) qui sont branchés en série et qui sont du deuxième type de conductivité différent du premier type de conductivité.

10. Dispositif CAM selon la revendication 9,
**caractérisé par le fait que** les quatre transistors à effet de champ (N ; P) du deuxième type de conductivité se trouvent en série par rapport à un circuit série - parallèle constitué de transistors à effet de champ (P ; N) du premier type de conductivité entre le noeud de coïncidence (17) et un potentiel de référence (V_{M}) .

11. Dispositif CAM selon l'une des revendications précédentes 7 à 10,
**caractérisé par le fait que** les transistors à effet de champ (P ; N) du premier type de conductivité forment un canal p et les transistors à effet de champ (N ; P) du deuxième type de conductivité forment un canal n.

12. Dispositif CAM selon l'une des revendications précédentes 7 à 10,
**caractérisé par le fait que** les transistors à effet de champ (P ; N) du premier type de conductivité forment un canal n et les transistors à effet de champ (N ; P) du deuxième type de conductivité forment un canal p.

13. Dispositif CAM selon l'une des revendications précédentes,
**caractérisé par le fait que** le dispositif de comparaison (16) comporte un dispositif de maintien (30) pour la conservation d'un niveau de signal sur le noeud de coïncidence (17).

14. Dispositif CAM selon la revendication 13,
**caractérisé par le fait que** le dispositif de maintien comporte trois transistors parmi lesquels un premier et un deuxième transistor forment un inverseur (I) dont l'entrée est reliée au noeud de coïncidence (17) et dont la sortie est raccordée à une grille du troisième transistor (N ; P).

15. Dispositif CAM selon l'une des revendications précédentes,
**caractérisé par le fait qu'**un circuit placé en amont du dispositif CAM et destiné à produire les deux bits de comparaison précodés peut être exploité de façon statique ou dynamique.

16. Dispositif CAM selon l'une des revendications précédentes,
**caractérisé par le fait que**, par l'intermédiaire du noeud de coïncidence (17), on peut commander aussi bien un trajet de coïncidence dit Passgate série qu'un trajet de coïncidence dit Wired Or.

17. Dispositif CAM selon l'une des revendications précédentes,
**caractérisé par le fait que** les dispositifs de mémorisation (10 ; 11) ont une structure identique et comportent chacun six transistors, quatre de ces derniers formant deux inverseurs antiparallèles (I).
